# EUROPEAN PATENT SPECIFICATION

(11) **EP 0 539 081 B1**
(45) Date of publication and mention of the grant of the patent: **25.03.1998**
(21) Application number: 92309316.5
(22) Date of filing: 13.10.1992
(51) Int. Cl.: G01R 15/20

(54) **Current sensor system or a method for current detection**
Stromsensorsystem oder Methode zur Stromerfassung
Système de capteurs de courant ou procédé de détection de courant

(30) Priority: 22.10.1991 JP 273717/91
(43) Date of publication of application: 28.04.1993
(73) Proprietor: HITACHI, LTD., Chiyoda-ku, Tokyo 101 (JP)
(72) Inventor: Takahashi, Tadashi, Hitachi-shi, Ibaraki 319-12 (JP); Kawamata, Syooichi, Hitachi-shi, Ibaraki 317 (JP); Morinaga, Shigeki, Hitachi-shi, Ibaraki 316 (JP)
(74) Representative: Molyneaux, Martyn William

(56) References cited:
- EP-A- 0 181 759
- EP-A- 0 300 635
- DE-A- 3 133 908
- Patent Abstracts of Japan, vol. 13, no. 60 (M - 796) & JP-A-63 263 346

## Description

The present invention relates to a current sensor system utilizing ferromagnetic magnetoresistance elements and bias conductors, especially, to the current sensor system and to a method for current detection utilizing bias conductors, current conductors, and magnetoresistance elements for the current sensor system.

A conventional current sensor system consists of a magnetoresistance element and a current conductor as described in a reference, C.H. Bejorek et al: A PERMALLOY CURRENT SENSOR: 813-815, Vol. MAG-12, No. 6 IEEE Trans. Mag. (November, 1976), and detects electric current flowing in the current conductor by determining resistance change of the magnetoresistance element.

The above described prior art has problems of insufficient accuracy of current detection and narrowness of current detecting range, because measures to prevent undue hysteresis of the magnetoresistance element and Barkhausen noise, and enlargement of the current detecting range were not considered.

DE-A-3133908 discloses a compensated measurement transducer which measures a first current which generates a first magnetic field in a first circuit including a first conductor. A second current substantially similar to the first current is generated in a second circuit and the first current is measured by obtaining the value of the second current. The second circuit includes a compensating current conductor which generates a second magnetic field compensating the first magnetic field, a Wheatstone bridge to which both magnetic fields are applied, and an amplifier connected to the output of the Wheatstone bridge and coupled to the compensating current conductor. In this reference the Wheatstone bridge is formed by thin films disposed in pairs one on top of the other. The thin films may be considered as magnetoresistive elements and these elements are mounted on top of a current conductor which in turn is mounted on top of a bias conductor.

Another form of current detecting device using a magnetoresistance element is disclosed in EP-A-0300635. This document discloses a current detecting device in which a bias conductor carrying a constant current is arranged between a magnetoresistive element and a conductor carrying the current to be measured. Patent Abstracts of Japan, Volume 13, No. 60 (M-796) representing JP-A-63263346 relates to a frequency control system and does not refer to a sensor of the form envisaged by this invention.

The present invention seeks to provide a current sensor system and method which can detect electric current with high accuracy without generating hysteresis and Barkhausen noise while using a magnetoresistance element, and which will also extend the current detecting range.

According to a first aspect of this invention there is provided a current sensor as claimed in claim 1 herein.

According to a further aspect of this invention there is provided a method for detecting a current as claimed in claim 2 herein.

According to another aspect of this invention there is provided a motor controlling apparatus as claimed in claim 3 herein.

In use of this invention, an output proportional to a sensing current can be obtained to make the internal resistance of the magnetoresistance element constant, and current detection in a wide range with desired preciseness can be obtained without the sensor being affected by hysteresis of the magnetoresistance element and Barkhausen noise.

As for concomitant effects, the following advantages are realized.

That is, the current sensor system relating to the present invention has a simple construction, and miniaturization becomes possible. Further, inductance can be small because the conductors are not arranged in a coil form, and accordingly, current detection with a required frequency characteristics is possible.

Further, another effect for reducing temperature increase can be realized by making the widths of the conductors wide in dependence upon the current to be carried so as to decrease heat generation.

If the width of the bias conductor is made wider than that of the magnetoresistance element, a bias magnetic field can be effectively added to the magnetoresistance element. Further, by making the width of the current conductor wider than that of the magnetoresistance element, and the width of the bias conductor intermediate that of the current conductor and the magnetoresistive element, an effect wherein magnetic field generated by the current conductor and the bias magnetic field can be effectively added to the magnetoresistance element.

A structure wherein the current conductor is arranged on an opposite side of the substrate to the magnetoresistance element makes it possible to increase the space between the magnetoresistance element, the bias conductor, and the current conductor, and accordingly, a large current can be detected because the magnetic field added to the MR element can be small even with the large current.

Dielectric strength of the current conductor and the magnetoresistance element can be improved. Moreover, temperature increase of the magnetoresistance element can be reduced because heat generated at the current conductor by a large current can be absorbed by the substrate.

Further, the present invention provides an industrial advantage by making it possible to obtain precise miniaturized control circuits for motor control.

A predetermined current flows in the bias conductor in order to add a bias magnetic field to the magnetoresistance element. When current flows in the current conductor under the above described condition, a magnetic field is generated and the resistance of the magnetoresistance element has to be changed, but, the magnetic field of the magnetoresistance element can be controlled to be substantially constant by controlling the bias current so as to cancel the resistance change, and consequently, hysteresis and Barkhausen noise of the magnetoresistance element are not generated. Further, as the operating point of the magnetoresistance element keeps a constant position, the element operates so as to make it possible to detect current in a wide range without being restricted to the operating range of current detection of the magnetoresistance element.

### Brief Description of the Drawings

FIG. 1 is a schematic drawing indicating a circuit using a current sensor in accordance with an embodiment of the present invention,
FIG. 2 is a graph of characteristics for explanation on operation of the present invention,
FIG. 3 is a section taken on line II-II in FIG. 1,
FIG. 4 is a section of a second embodiment,
FIG. 5 is section of a third embodiment,
FIG. 6 is section of a fourth embodiment,
FIG. 7 is a section of a fifth embodiment,
FIG. 8 is a section of a sixth embodiment,
FIG. 9 is a schematic drawing indicating a circuit using a current sensor in accordance with another embodiment of the present invention,
FIG. 10 is a schematic drawing indicating a circuit using a current sensor in accordance with a further embodiment of the present invention,
FIG. 11 is a schematic drawing indicating an embodiment of the invention applied to motor control,
FIG. 12 is a schematic drawing indicating a further embodiment of the invention applied to motor control, and
FIG. 13 is a schematic drawing indicating another embodiment of the invention applied to motor control.

### Detailed Description of the Embodiments

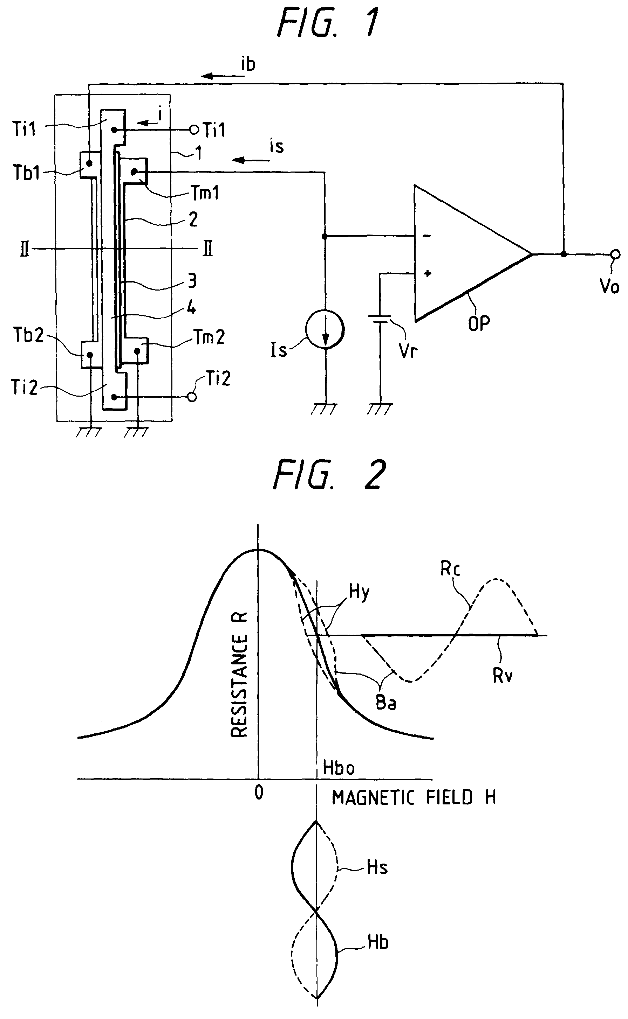

Hereinafter, one of the preferred embodiments of the present invention will be explained referring to FIG. 1.

FIG. 1 shows a circuit of a current sensor system. Referring to FIG. 1, an insulated substrate 1 is composed from insulating materials such as glass, ceramics, and reinforced plastics etc. A magnetoresistance element (MR element) 2 is mounted on the substrate 1, and the bias conductor 3 is mounted on the element 2. A current conductor 4 is mounted on the bias conductor 3 to form a sensor portion. The MR element 2 has terminals, Tm1 and Tm2 which are connected to a constant current source is supplying constant current, is.

The bias conductor 3 has terminals, Tb1 and Tb2, one of which is connected to the output of an amplifier (processing amplifier) OP, the bias conductor being supplied with bias current ib.

The current conductor 4 has terminals, Ti1 and Ti2, through which it is supplied with unmeasured current from an external lead wire.

The terminal Tm1 of the MR element 2 and a standard voltage Vr are connected to an input of the amplifier OP.

Now, a case when current at the current conductor 4 is zero (i0) with the above described circuit will be considered. The standard voltage Vr is transferred to the output of the amplifier OP in order to generate an output voltage Vo0. Depending on the output voltage Vo0, a bias current, is0, flows through the bias conductor 3 and a magnetic field Hb0 is added to the MR element. Next, another case when a current, i1, flows through the current conductor 4 will be considered. Output of the amplifier becomes Vo1, and the output voltage Vo1 causes bias current, is1, at the bias conductor, and further, current at the bias conductor changes from ib0 to ib1 so as to cancel the magnetic field Hs1 that is generated by the current, i1, of the current conductor 4. Consequently, the magnetic field of the MR element is unchanged and remains at Hb0. Accordingly, a voltage change (from V00 to V01) which is proportional to the current at the current conductor 4 is added to the output terminal Vo as an output of the amplifier.

Referring to Fig. 2 the above described operation is explained. FIG. 2 indicates a characteristic of resistance versus magnetic field of the MR element, the solid line indicates an ideal characteristic and the dashed line indicates the characteristic of another case with hysteresis and Barkhausen noise.

When current at the current conductor 4 is zero, the magnetic field which is added to the MR element is Hb0, and resistance of the MR element is Rv. Next, a case when sine wave current, i, flows through the current conductor 4 is considered. In this case, the magnetic field Hs indicated by the dashed line in FIG. 2 is generated by the current, i, but the circuit previously described referring to FIG. 1 changes the bias magnetic field Hb indicated by the solid line by altering the current ib of the bias conductor so as to cancel the magnetic field Hs, and consequently,resistance of the MR element is kept constant as indicated by solid line Rv because the magnetic field of the MR element is kept at original Hb0. If the magnetic field of the MR element were allowed to change to Hs without cancellation thereof, as required by the present invention, resistance of the MR element would become Rc as indicated with a dashed line in FIG. 2, and effects of hysteresis and Barkhausen noise would not be avoided.

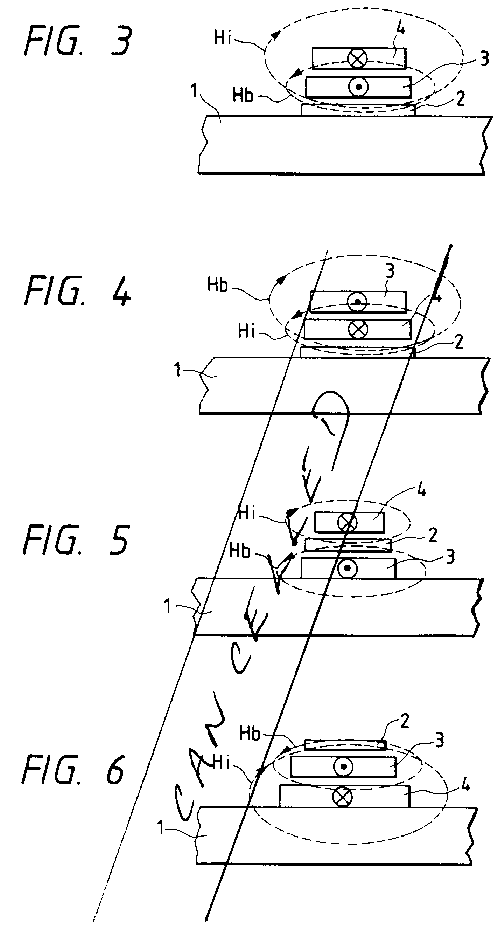

FIG. 3 is a section taken on line II-II in FIG. 1.

The magnetic field Hb indicted with a dashed line is generated by flowing bias current in the bias conductor 3 in a direction shown in FIG. 3, and the magnetic field is added to the MR element 2. When current flows in the current conductor 4 in a direction shown in FIG. 3, the magnetic field Hi indicated with a dashed line is added to the MR element 2.

In the present invention, the magnetic field added to the MR element is operated to be always constant and an output proportional to a sensing current can be obtained; consequently, wide range and precise current sensing without being affected by hysteresis and Barkhausen noise of the MR element is possible, and simplification of structure and miniaturization of the current sensor systems is possible. Further, because each conductor is not arranged as a coil but as a stripe, inductance can be small, and current sensing with desired frequency characteristics is realized.

FIG. 4 is a drawing indicating a further embodiment, in which the current conductor 4 is made thicker than the thickness of the bias conductor 3 in order to decrease electric resistance for reducing heat generation by current. In this respect the current conductor 4 permits a larger current than the bias conductor 3 as compared to the arrangement shown in FIG.3 where the conductors 3 and 4 have the same thickness. Similar effect to reduce heat generation by current is realized by making the thickness of the bias conductor 3 thicker than the thickness of the MR element to permit a larger current in the conductor 3 than in the MR element.

FIG. 5 shows another embodiment, in which, to facilitate ease of manufacture of the sensor, the widths of the current conductor 4, the bias conductor, and the MR element are the same whereas in FIG. 3 the widths are different from one another.

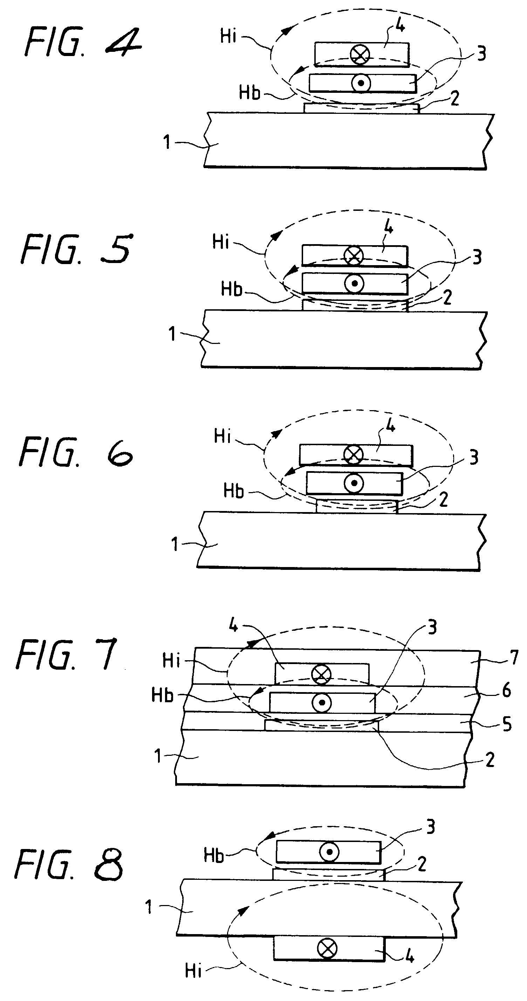

FIG. 6 is another embodiment, wherein to reduce heat generation and temperature rise by decreasing electric resistance, the widths of the respective conductors are increased the further the conductor is away from the substrate - compare with the embodiment shown in FIG. 3. Further, by making the width of the bias conductor wider than the MR element, the bias magnetic field can effectively be added to the MR element. Moreover, the magnetic field generated by the current conductor and the bias magnetic field can effectively be added to the MR element by making the width of the current conductor which is located furthest from the MR element largest and the width of the bias conductor the next largest.

FIG.7 is another embodiment which is a modification of Fig. 3 in which insulating members 5, 6, 7, respectively are arranged with the MR element 2, the bias conductor 3, and the current conductor 4. For the insulating members 5, 6, 7, materials such as SiO₂, resin, etc. may be used, and not only monolayer but also double layers of SiO₂ and resin may be advantageously used to enhance insulating properties.

FIG. 8 is a further embodiment of a sensor used when the detecting current is large, or when the dielectric strength between an electric current detecting terminal and the bias conductor or the MR element must be kept high. In Fig. 8, the current conductor 4 is arranged to be on the reverse side of the substrate 1 to the MR element 2. In such an arrangement, distances between the MR element, the bias conductor, and the current conductor may be increased so sensing of a large current is possible because the magnetic field generated by such a large current can be made small. Further, the dielectric strength of the current conductor and the MR element can be increased. Moreover, because heat, generated by the current conductor which enables the large current to flow, can be absorbed by the substrate 1, temperature increase is reduced.

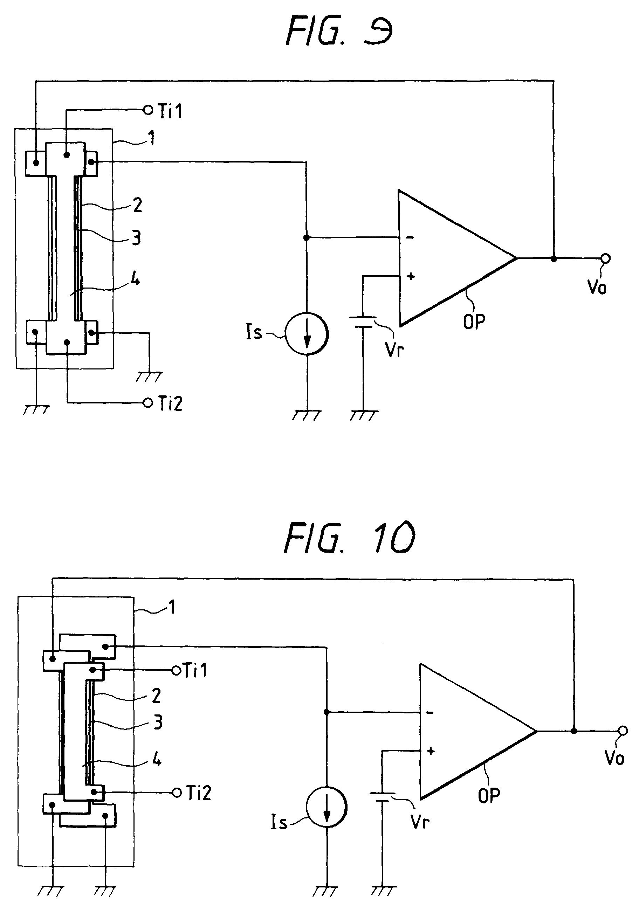

FIG. 9 illustrates an embodiment where the respective lengths of the MR element, the bias conductor, and the current conductor of the sensing portion are made the same in comparison with the different lengths shown in Fig. 1. In Fig. 9, magnetic fields generated by respective conductors can effectively be added to the MR element.

FIG. 10 illustrates another embodiment where the respective lengths of the MR element, the bias conductor and the current conductor of the sensing portion are made shorter with increasing distance away from the substrate. In Fig. 10 by virtue of providing different lengths of conductor at different heights above the substrate so edge portions do not overlap thereby easing manufacture.

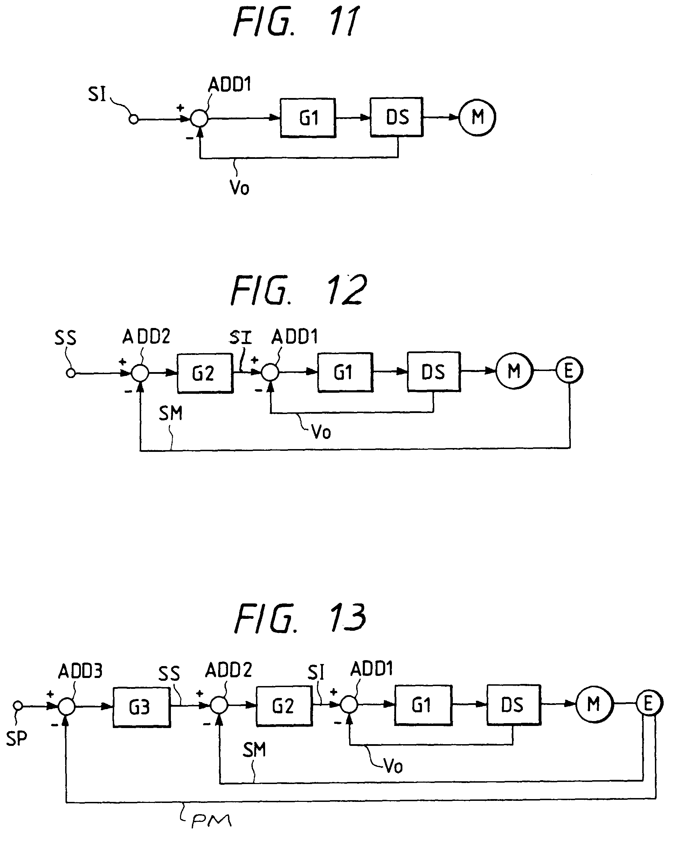

FIG. 11 shows an example of the current sensor system applied to current control of a motor.

A deviation between the current instruction SI and the output V0 from the current sensor system DS connected to the motor is produced at an additive point ADD1, and an output from the additive point is amplified by G1 and used for driving the motor. The arrangement operates so as to make the deviation at the additive point zero so the motor current is controlled to be equal to the instruction current. Either of the sensors shown in Figs. 1 and 10 may be used, and consequently, preciseness of current sensing is improved and more precise control of the motor is possible. Further, the size of the current sensor system is decreased, and an arrangement of the current sensor system on a printed substrate with a motor control circuit is possible.

FIG. 12 shows an example of application of the invention to speed controlling apparatus.

Deviation between the speed instruction SS and the speed signal SM from an encoder E for detecting the speed of a motor is determined by comparison at point ADD2, and the current instruction SI is obtained by multiplying the deviation by a coefficient G2. Next, a deviation between the current instruction SI and the output V0 from the current sensor system DS which is connected to a motor circuit is taken at the point ADD1, and an output from the additive point is amplified by G1 and used for driving the motor. Accordingly, as the arrangement operates so as to make the deviation at the additive point ADD2 zero so the motor speed is controlled to be equal to the instruction speed SS. Such a current sensor system may use either of the sensors shown in Figs. 1 and 10, and consequently, preciseness of current sensing is improved and more precise control of speed is possible. Further, the size of the current sensor system is decreased, and an arrangement of the current sensor system on a printed substrate with a motor control circuit is possible.

FIG.13 shows an example of application of the invention to position controlling apparatus.

A deviation between a position instruction SP and a position signal PM from an encoder E for detecting position of a motor is produced by comparison at an additive point ADD3, and a speed instruction SS is produced by multiplying the deviation by a coefficient G3. Next, a deviation between the speed instruction SS and the speed signal SM from the encoder E for detecting the speed of a motor is produced by comparison at the additive point ADD2 and the current instruction SI is made by multiplying the deviation by the coefficient G2. Subsequently, a deviation between the current instruction SI and the output V0 from the current sensor system DS which is connected to a motor circuit is taken at the additive point ADD1, and an output from the additive point is amplified by G1 and used for driving the motor. Accordingly, the arrangement makes the deviation at the additive point ADD3 zero so that the motor position is controlled to be equal to the instruction position SP. The sensors shown in Figs. 1 or 10 may be used, and consequently, preciseness of current sensing is improved and more precise control of position is rendered possible. Further, the size of the current sensor system is made smaller and an arrangement of the current sensor system on a printed substrate with a motor control circuit is made possible.

## Claims

1. A current sensor system for sensing a subject current (i) comprising:
an insulating substrate (1) made from glass or ceramics,
a single elongate magnetoresistive element (2) which is arranged on the insulating substrate (1),
a bias conductor (3) arranged on and parallel to said magnetoresistive element (2),
a current conductor (4) having terminals (Ti1, Ti2) supplied with the subject current (i) to be measured from an external lead wire, said current conductor (4) being arranged parallel to said magnetoresistive element (2) either on the bias conductor (3) or on the other side of the insulating substrate (1) from the magnetoresistive element (2) and being disposed further from the magnetoresistive element (2) than said bias conductor (3), and
a circuit for supplying a bias current (ib) to said bias conductor (3) to cancel the variation of the resistance of the magnetoresistive element (2) due to the variation of the magnetic field produced by the subject current (i) flowing through the current conductor (4) whereby said subject current (i) is detected from the value of the bias current (ib) flowing through the bias conductor (3).

2. A method for detecting a subject current (i) comprising the steps of:
providing an insulating substrate (1) made from glass or ceramics,
arranging a single elongate magnetoresistive element (2) on the insulating substrate (1),
arranging a bias conductor (3) close on and parallel to said magnetoresistive element (2),
providing a current conductor (4) having terminals (Ti1, Ti2) supplied with the subject current (i), said current conductor (4) being arranged parallel to said magnetoresistive element (2) either on the bias conductor (3) or on the other side of the insulating substrate (1) from the magnetoresistive element (2) and being disposed further from the magnetoresistive element (2) than the bias conductor (3),
providing a constant current (is) through said magnetoresistive element (2),
providing a bias current (ib) to said bias conductor (3) to cancel the variation of the resistance of the magnetoresistive element (2) due to the variation of the magnetic field produced by the subject current (i) flowing through the current conductor (4), and
detecting a subject current (i) by determining the value of said bias current (ib) required to cancel the variation of said resistance.

3. A motor controlling apparatus having a current sensor system for detecting a subject current (i) in the motor and
controlling the motor by regulating the current detected by the current sensor system so as to coincide with an instruction current, wherein said current sensor system comprises:
an insulating substrate (1) made from glass or ceramics,
a single elongate magnetoresistive element (2) which is arranged on the insulating substrate (1),
a bias conductor (3) arranged on and parallel to said magnetoresistive element (2),
a current conductor (4) having terminals (Ti1, Ti2) supplied with the subject current (i) to be measured from an external lead wire, said current conductor (4) being arranged parallel to said magnetoresistive element (2) either on the bias conductor (3) or on the other side of the insulating substrate (1) from the magnetoresistive element (2) and being disposed further from the magnetoresistive element (2) than said bias conductor (3), and
a circuit for supplying a bias current (ib) to said bias conductor (3) to cancel the variation of the resistance of the magnetoresistive element (2) due to the variation of the magnetic field produced by the subject current (i) flowing through the current conductor (4) whereby said subject current (i) is detected from the value of the bias current (ib) flowing through the bias conductor (3).

## Patentansprüche

1. Stromsensorsystem zur Erfassung eines vorliegenden Stroms (i), wobei das System folgendes umfaßt:
ein isolierendes Substrat (1) aus Glas oder einem Keramikwerkstoff;
ein einzelnes elongiertes Magneto-Widerstandselement (2), das auf dem isolierenden Substrat (1) angeordnet ist;
einen Vormagnetisierungsleiter (3), der an dem genannten Magneto-Widerstandselement (2) und parallel zu diesem angeordnet ist;
einen Stromleiter (4) mit Anschlüssen (Ti1, Ti2), denen der vorliegende Strom (i) zugeführt wird, der von einem externen Führungsdraht gemessen wird, wobei der genannte Stromleiter (4) parallel zu dem genannten Magneto-Widerstandselement (2) entweder an dem Vormagnetisierungsleiter (3) oder auf der zu dem Magneto-Widerstandselement entgegengesetzten Seite des isolierenden Substrats (1) angeordnet ist, und zwar weiter von dem Magneto-Widerstandselement (2) entfernt als der genannte Vormagnetisierungsleiter (3); und
einen Schaltkreis für die Zufuhr eines Vormagnetisierungsstroms (ib) zu dem genannten Vormagnetisierungsleiter (3), um die Widerstandsveränderung des Magneto-Widerstandselements (2) auszugleichen, die durch eine Veränderung des Magnetfelds bewirkt wird, das durch den durch den Stromleiter (4) fließenden vorhandenen Strom (i) erzeugt wird, wobei der genannte vorliegende Strom (i) aus dem Wert des Vormagnetisierungsstroms (ib) erfaßt wird, der durch den Vormagnetisierungsleiter (3) fließt.

2. Verfahren zur Erfassung eines vorliegenden Stroms (i), wobei das Verfahren die folgenden Schritte umfaßt:
Bereitstellen eines isolierenden Substrats (1) aus Glas oder Keramikwerkstoff;
Anordnen eines einzelnen elongierten Magneto-Widerstandselements (2) auf dem isolierenden Substrat (1);
Anordnen eines Vormagnetisierungsleiters (3) nahe an und parallel zu dem genannten Magneto-Widerstandselement (2);
Bereitstellen eines Stromleiters (4) mit Anschlüssen (Ti1, Ti2), denen der vorliegende Strom (i) zugeführt wird, wobei der Stromleiter (4) parallel zu dem genannten Magneto-Widerstandselement (2) entweder an dem Vormagnetisierungsleiter (3) oder auf der zu dem Magneto-Widerstandselement (2) entgegengesetzten Seite des isolierenden Substrats (1) angeordnet ist, und zwar weiter von dem Magneto-Widerstandselement (2) entfernt als der genannte Vormagnetisierungsleiter (3);
Bereitstellen eines konstanten Stroms (is) durch das genannte Magneto-Widerstandselement (2);
Bereitstellen eines Vormagnetisierungsstroms (ib) zu dem genannten Vormagnetisierungsleiter (3), um die Widerstandsveränderung des Magneto-Widerstandselements (2) auszugleichen, die durch eine Veränderung des Magnetfelds bewirkt wird, das durch den durch den Stromleiter (4) fließenden vorhandenen Strom (i) erzeugt wird; und
Erfassen eines vorliegenden Stroms (i) durch Bestimmung des Wertes des genannten Vormagnetisierungsstroms (ib), der für den Ausgleich der Veränderung des genannten Widerstands erforderlich ist.

3. Motorsteuerungsvorrichtung mit einem Stromsensorsystem zur Erfassung eines vorliegenden Stroms (i) in dem Motor, und wobei
der Motor durch Regelung des durch das Stromsensorsystem erfaßten Stroms gesteuert wird, so daß dieser mit einem Befehlsstrom zusammenfällt, wobei das genannte Stromsensorsystem folgendes umfaßt:
ein isolierendes Substrat (1) aus Glas oder einem Keramikwerkstoff;
ein einzelnes elongiertes Magneto-Widerstandselement (2), das auf dem isolierenden Substrat (1) angeordnet ist;
einen Vormagnetisierungsleiter (3), der an dem genannten Magneto-Widerstandselement (2) und parallel zu diesem angeordnet ist;
einen Stromleiter (4) mit Anschlüssen (Ti1, Ti2), denen der vorliegende Strom (i) zugeführt wird, der von einem externen Führungsdraht gemessen wird, wobei der genannte Stromleiter (4) parallel zu dem genannten Magneto-Widerstandselement (2) entweder an dem Vormagnetisierungsleiter (3) oder auf der zu dem Magneto-Widerstandselement entgegengesetzten Seite des isolierenden Substrats (1) angeordnet ist, und zwar weiter von dem Magneto-Widerstandselement (2) entfernt als der genannte Vormagnetisierungsleiter (3); und
einen Schaltkreis für die Zufuhr eines Vormagnetisierungsstroms (ib) zu dem genannten Vormagnetisierungsleiter (3), um die Widerstandsveränderung des Magneto-Widerstandselements (2) auszugleichen, die durch eine Veränderung des Magnetfelds bewirkt wird, das durch den durch den Stromleiter (4) fließenden vorhandenen Strom(i) erzeugt wird, wobei der genannte vorliegende Strom (i) aus dem Wert des Vormagnetisierungsstroms (ib) erfaßt wird, der durch den Vormagnetisierungsleiter (3) fließt.

## Revendications

1. Système de capteur de courant pour détecter un courant considéré (i), comprenant :
un substrat isolant (1) en verre ou céramique,
un élément magnétorésistif allongé unique (2) qui est placé sur le substrat isolant (1),
un conducteur de polarisation (3) placé sur le dit élément magnétorésistif (2) et parallèle à celui-ci,
un conducteur de courant (4) ayant des bornes (Ti1, Ti2) alimentées avec le courant considéré (i) à mesurer, amené par un conducteur extérieur, ledit conducteur de courant (4) étant placé parallèlement audit élément magnétorésistif (2) sur le conducteur de polarisation (3) ou sur l'autre côté du substrat isolant (1) par rapport à l'élément magnétorésistif (2), et étant plus éloigné de l'élément magnétorésistif (2) que ledit conducteur de polarisation (3), et
un circuit de fourniture d'un courant de polarisation (ib) audit conducteur de polarisation (3) pour annuler la variation de la résistance de l'élément magnétorésistif (2) due à la variation du champ magnétique produit par le courant considéré (i) circulant dans le conducteur de courant (4), de sorte que ledit courant considéré (i) est détecté à partir de la valeur du courant de polarisation (ib) circulant dans le conducteur de polarisation (3).

2. Procédé de détection d'un courant considéré (i), comprenant les étapes de :
préparation d'un substrat isolant (1) en verre ou céramique,
agencement d'un élément magnétorésistif allongé unique (2) sur le substrat isolant (1),
agencement d'un conducteur de polarisation (3) sur ledit élément magnétorésistif (2) et parallèlement à celui-ci,
préparation d'un conducteur de courant (4) ayant des bornes (Ti1, Ti2) alimentées avec le courant considéré(i), ledit conducteur de courant (4) étant placé parallèlement audit élément magnétorésistif (2) sur le conducteur de polarisation (3) ou sur l'autre côté du substrat isolant (1) par rapport à l'élément magnétorésistif(2)et étant plus éloigné de l'élément magnétorésistif (2) que le conducteur de polarisation (3),
passage d'un courant constant (is) dans ledit élément magnétorésistif (2),
passage d'un courant de polarisation (ib) dans ledit conducteur de polarisation (3) pour annuler la variation de la résistance de l'élément magnétorésistif (2) due à la variation du champ magnétique produit par le courant considéré (i) circulant dans le conducteur de courant (4), et
détection d'un courant considéré (i) par détermination de la valeur dudit courant de polarisation (ib) nécessaire pour annuler la variation de ladite résistance.

3. Appareil de commande de moteur comportant un système de capteur de courant pour détecter un courant considéré (i) dans le moteur et pour commander le moteur par régulation du courant détecté par le système de capteur de courant, de sorte qu'il coïncide avec un courant de consigne, dans lequel ledit système de capteur de courant comprend :
un substrat isolant (1) en verre ou en céramique,
un élément magnétorésistif allongé unique (2) qui est placé sur le substrat isolant (1),
un conducteur de polarisation (3) placé sur ledit élément magnétorésistif (2) et parallèle à celui-ci,
un conducteur de courant (4) ayant des bornes (Ti1,Ti2) alimentées avec le courant considéré (i) à mesurer amené par un conducteur extérieur, ledit conducteur de courant (4) étant placé parallèlement audit élément magnétorésistif (2) sur le conducteur de polarisation (3) ou sur l'autre côté du substrat isolant (1) par rapport à l'élément magnétorésistif (2) et étant disposé plus loin de l'élément magnétorésistif (2) que le dit conducteur de polarisation (3), et
un circuit de fourniture d'un courant de polarisation (ib) audit conducteur de polarisation (3) pour annuler la variation de la résistance de l'élément magnétorésistif (2) due à la variation du champ magnétique produit par le courant considéré (i) circulant dans le conducteur de courant (4), de sorte que ledit courant considéré (i) est détecté à partir de la valeur du courant de polarisation (ib) circulant dans le conducteur de polarisation (3).
